# EUROPÄISCHE PATENTSCHRIFT

(11) **EP 1 228 526 B1**
(45) Veröffentlichungstag und Bekanntmachung des Hinweises auf die Patenterteilung: **11.02.2004**
(21) Anmeldenummer: 00977520.6
(22) Anmeldetag: 09.11.2000
(51) Int. Cl.: H01L 21/00

(54) **VORRICHTUNG ZUM BESTÜCKEN VON TEILETRÄGERN FÜR MIKROSYSTEME**
DEVICE FOR ASSEMBLY OF COMPONENT SUPPORTS FOR MICROSYSTEMS
DISPOSITIF POUR METTRE EN PLACE DES COMPOSANTS SUR DES SUPPORTS DE PIECES DESTINES A DES MICROSYSTEMES

(30) Priorität: 09.11.1999 DE 19953949
(43) Veröffentlichungstag der Anmeldung: 07.08.2002
(73) Patentinhaber: Asys Gmbh + Co. Kg, 73614 Schorndorf (DE)
(72) Erfinder: HÜGLER, Klaus, 73630 Remshalden (DE)
(74) Vertreter: Wittner, Walter
(86) Internationale Anmeldenummer: PCT/EP2000/011067
(87) Internationale Veröffentlichungsnummer: WO 2001/035449

(56) Entgegenhaltungen:
- US-A- 3 957 185
- US-A- 5 313 401
- PATENT ABSTRACTS OF JAPAN vol. 1995, no. 09, 31. Oktober 1995 (1995-10-31) -& JP 07 147300 A (HITACHI LTD;OTHERS: 01), 6. Juni 1995 (1995-06-06)
- PATENT ABSTRACTS OF JAPAN vol. 1998, no. 02, 30. Januar 1998 (1998-01-30) -& JP 09 283998 A (MATSUSHITA ELECTRIC IND CO LTD), 31. Oktober 1997 (1997-10-31)
- PATENT ABSTRACTS OF JAPAN vol. 018, no. 033 (E-1493), 18. Januar 1994 (1994-01-18) -& JP 05 267363 A (TOSHIBA CORP), 15. Oktober 1993 (1993-10-15)
- PATENT ABSTRACTS OF JAPAN vol. 007, no. 280 (E-216), 14. Dezember 1983 (1983-12-14) -& JP 58 158940 A (TOKYO SHIBAURA DENKI KK), 21. September 1983 (1983-09-21)

## Beschreibung

Die Erfindung betrifft eine Vorrichtung zum Bestücken von Teileträgern für Mikrosysteme, insbesondere ein Prozessmodul für in Clusterbauweise aufgebaute Arbeitszentren, gemäß dem Anspruch 1.

Aus der DE 196 54 231 A1 ist eine Handlingeinheit für Bauteile bekannt, die in einer atmosphärisch abgegrenzten Kammer eine Arbeitsstation aufweist, in der Bauteile auf einer Ringzone eines Drehteller angeordnet sind, der aus einer Beladestation beschickt wird. Die Kammer enthält weiter eine Messstation sowie eine Dreharmeinheit, deren Arme beim Umlauf einen Sektor der mit Bauteilen belegten Ringzone des Drehtellers überstreichen und höhenverstellbare Sauggreifer umfassen, über die die Bauteile vom Drehteller aufgenommen, in die Messstation überführt und aus der Messstation in den Überlappungsbereich zu einer außerhalb der Arbeitskammer liegenden Dreharmeinheit transportiert werden, die eine Entnahmestufe bildet und von der die Bauteile in eine Entladestation überführt werden.

Die Messstation liegt höhenversetzt zu einem Zwischenspeicher bildenden Drehteller und zur die Entnahmestufe bildenden Dreheinheit und es ist eine Kurvenführung vorgesehen, durch die die Sauggreifer auf ihrem Weg vom Drehteller zur Messstation und von der Messstation zur Entnahmestufe in Höhenrichtung geführt werden. Diese Führungseinrichtung ist als sowohl nach oben wie auch nach unten wegbegrenzte Zwangsführung ausgebildet, um einen ungewollten Höhenversatz der Sauggreifer auf ihrem Durchlaufweg und dadurch bedingte Schäden auszuschließen.

Aus der DE 196 06 764 C1 ist eine zentrale Handlingeinheit zum Greifen, Halten und/oder Transportieren von Substraten bekannt und es ist die Handlingeinheit zentral zu umschließenden Stationen angeordnet, nämlich Be- und Entladestationen, sowie auch Bearbeitungsstationen. Ausgebildet ist die Handlingeinheit als Karussell mit diversen zur Karussellachse radial auskragenden Tragarmen, die Substratgreifer tragen, welche beim Umlauf des Karussells den Transport der Substrate zwischen den einzelnen Stationen, die ihrerseits teilweise als unabhängig vom Karussell und exzentrisch zur Karussellachse ausgebildeten Drehtische oder Karusselle ausgebildet sind, übernehmen. Neben lagefest zueinander stehenden Karussellarmen umfasst das Karussell auch mindestens einen Karussellarm, der seinerseits relativ zu den anderen Karussellarmen im Bezug auf die gemeinsame Karussellachse verschwenkbar ist, um die Arbeitsflexibilität zu vergrößern.

Des Weiteren ist aus der DE 44 18 142 A1 das Aufbauprinzip einer Arbeitsvorrichtung bekannt, die zwei Greifer umfasst, die gegen eine gemeinsame Basis bei zueinander senkrechter Erstreckung ihrer Bewegungsachsen hubverstellbar sind, wobei die Basis um eine zu den Bewegungsachsen der Greifer unter 45° geneigte Achse drehbar ist, so dass die Greifer durch Verdrehen der Basis um 180° ihre jeweilige Ausgangsposition tauschen. Eine im prinzipiellen Aufbau entsprechende Vorrichtung zeigt auch die DE 41 17 969 A1.

In Verbindung mit Mikrosystemen finden scheibenförmige Gebilde unter anderem in Form von Werkstücken, die mit Bauelementen zu bestücken sind, oder in Form von Paletten Verwendung, die Träger für Bauelemente bilden, welche für die Bestückung von Werkstücken bereitzuhalten sind. Da im Rahmen der Bestückung eines Werkstückes meist unterschiedliche Bauelemente Verwendung finden, kann die Zuordnung unterschiedlicher Bauelemente zu einer Palette im Rahmen der Vorbereitung auf die Bestückung von Werkstücken zweckmäßig sein. Mit der entsprechenden Auswahl ist ein Sortiervorgang verbunden, der ausgehend von mit gleichen Bauteilen belegten Paletten zu Paletten führt, die mit unterschiedlichen Bauteilen belegt sind. Entsprechend kann auch eine unmittelbare Bestückung von Werkstücken ausgehend von mehreren Paletten, die mit einheitlichen oder unterschiedlichen Bauelementen belegt sind, durchzuführen sein.

Zum Bonden von Halbleiterelementen ist es aus der im Oberbegriff des Anspruches 1 berücksichtigten JP-A-07 147 300 bekannt, einen drehbaren Planetentisch, dessen zum Tisch drehbare Planeten in Hochrichtung beaufschlagende Hubelemente sowie eine bezogen auf die Planeten als Arbeitsinseln den Hubelementen gegenüberliegende Arbeitseinheit translatorisch gegeneinander verschiebbar zu einer Vorrichtung zu verknüpfen, um mit Hilfe einer Beobachtungsoptik die wechselseitige Ausrichtung und Positionierung im Hinblick auf den jeweiligen Arbeitsvorgang durchzuführen. Entsprechende translatorische Verstellvorgänge bedingen insbesondere bei einzuhaltenden engen Toleranzen einen erheblichen Aufwand, sind hinsichtlich hoher Arbeitsgeschwindigkeiten kritisch sowie auch im Hinblick auf die Einhaltung der für ein Arbeiten unter Reinraumbedingungen notwendigen Voraussetzungen problematisch. Die Beschickung der Arbeitsinseln des Planetentisches erfolgt über eine drehbare Greifereinheit, die seitlich versetzt zum Planetentisch angeordnet ist und radial zu ihrer Drehachse auskragende Greiferbereiche aufweist, welche in die von den Arbeitsinseln bei Rotation des Planetentisches überstrichene Ringzone überlappend eingreifen.

In Verbindung mit Bestückungssystemen für Werkstücke in Form von Leiterplatten ist es aus der US-A-5 313 401 bekannt, eine Greifereinheit mit einem Greiferkopf zu versehen, der - bezogen auf eine Senkrechte zu einem Werkstück, in der der Arbeitspunkt liegt - eine geneigte Drehachse aufweist und der mit in Umfangsrichtung zueinander beabstandet liegenden Werkzeugen versehen ist, die als Hubstempel ausgebildet sind und deren Hubachse in ihrer auf den Arbeitspunkt ausgerichteten Stellung mit der den Arbeitspunkt enthaltenden Senkrechten zusammenfällt. Eine solche Anordnung erlaubt zwar bei raumsparender Bauweise einen guten Zugriff auf den jeweiligen Arbeitspunkt mit den verschiedenen dem Greiferkopf zugeordneten Werkzeugen, gleichzeitig überdeckt aber die die Werkzeuge tragende Platte des Greiferkopfes weitgehend den Blickbereich auf den Arbeitspunkt, so dass eine gesteuerte Ausrichtung erschwert ist.

Der Erfindung liegt die Aufgabe zugrunde, eine für Bestückungsund/oder Sortiervorgänge geeignete Vorrichtung zu schaffen, mit der sich bei einfachem, raumsparendem, hohe Verstellgeschwindigkeiten ermöglichendem Aufbau ein Zugriff auf die Arbeitsinseln über deren gesamte Fläche bei Ausrichtung auf variierende Bauteilkonturen erreichen lässt, die insbesondere auch als Prozessmodul für in Clusterbauweise aufgebaute und/oder in Reinraumtechnik betriebene Arbeitszentren zu nutzen ist.

Erfindungsgemäß wird hierzu eine Vorrichtung der eingangs genannten Art gemäß dem Kennzeichen des Anspruches 1 ausgestaltet, wobei es die Drehung des Planetenträgers in Verbindung mit der Drehung der Planeten als Arbeitsinseln gegenüber dem Planetenträger ermöglicht, innerhalb der bei Drehung des Planetenträgers von den Arbeitsinseln beschriebenen Ringfläche durch wechselseitige Drehung von Planetenträger und Arbeitsinseln gegeneinander jeden Punkt derselben auf einer Kreislinie durch die Drehachsen der Arbeitsinseln zu platzieren, deren Mittelpunkt mit der Drehachse des Planetenträgers zusammenfällt, so dass bei vorrichtungsfester Platzierung des Planetenträgers und der Greifereinheit durch Drehung der Greifereinheit um ihre vorrichtungsfeste Drehachse zusätzlich eine Ausrichtung auf die Kontur von zu erfassenden Bauteilen möglich wird, und zwar bei ausschließlich rotierender Beweglichkeit von Planetenträger, Arbeitsinseln und Greifeinheit.

Infolge des parallelen Verlaufes der Trägerachsen von Planetenträger, Arbeitsinseln und Greifereinheit ergeben sich auch verbesserte Voraussetzungen für eine wechselseitige Verstellbarkeit, wobei sowohl der Planetenträger insgesamt, also mit Arbeitsinseln gegenüber der Greifereinheit höhenverstellbar sein kann, als auch die Arbeitsinseln zum Planetenträger. Des Weiteren können die durch die Planeten gebildeten Arbeitsinseln gemeinsam oder auch einzeln angetrieben sein, wobei der Einzelantrieb eine im Hinblick auf die Gesamtarbeitsgeschwindigkeit vorteilhafte Lösung darstellt.

Für die Greifereinheit erweist sich eine Ausgestaltung als zweckmäßig, bei der ein Greiferkopf in Form eines mehrfingrigen Drehrevolvers vorgesehen wird, der seinerseits in der Greifereinheit drehbar ist, bevorzugt um eine zur Drehachse der Greifereinheit geneigte Drehachse. Die Neigung der Drehachse des Drehrevolvers gegenüber der Drehachse der Greifereinheit erfolgt vorzugsweise unter einem Winkel von 45°. Entsprechend sind die Finger des Drehrevolvers zu dessen Drehachse abgewinkelt, so dass bei Drehung des Drehrevolvers dieser mit seinen Armen beim Durchlauf durch die Drehachse Greifereinheit in einer zu dieser senkrechten Ebene verläuft. Die Ausbildung des Greiferkopfes als mehrfingriger Drehrevolver ermöglicht bei der geschilderten Gestaltung der Greifereinheit die unmittelbare Beobachtung des Arbeitspunktes im Übergang zwischen aufeinander folgenden, durchlaufenden Revolverarmen.

In Verbindung damit erweist es sich insbesondere als zweckmäßig, die Greifereinheit mit einer auf den Arbeitspunkt ihres Greiferkopfes ausgerichteten Beobachtungsoptik auszustatten, über die sowohl die Positionierung zu beobachten ist als auch die Justierung zu überwachen ist. Ferner ermöglicht dies in vorteilhafter Weise die Erkennung und gegebenenfalls auch Prüfung. von Bauteilen, die im Arbeitspunkt liegen oder den Arbeitspunkt durchlaufen.

Im Rahmen der Erfindung ist es zweckmäßig, den Revolverfingern in ihrem zum Arbeitspunkt zur Überdeckung kommenden Bereich Greiferelemente, bevorzugt jeweils ein Saugelement als Sauggreifer zuzuordnen, der über der Umlaufbahn des Drehrevolvers alternierend an Saug- und Druckluft bzw. Atmosphäre angeschlossen ist, so dass bei Sauganschluss ein Aufgreifen und Transportieren des Bauteiles möglich ist, und bei Druckanschluss eine gezielte Ablage. Im Hinblick auf diese Funktion erweist es sich als zweckmäßig, die Saug- bzw. Druckluftführung über die Drehachse des Drehrevolvers zu leiten.

Im Hinblick auf die Erfassungsfunktion des Drehrevolvers für jeweils abgelegte Bauteile, die gegebenenfalls in Kavitäten von Paletten oder dergleichen liegen, erweist es sich als zweckmäßig, den Drehrevolver höhenverstellbar anzuordnen, und zwar höhenverstellbar insbesondere in Richtung der Drehachse der Greifereinheit.

Eine diesbezügliche einfache und zweckmäßige Konstruktion ergibt sich dadurch, dass die Greifereinheit für den Drehrevolver eine zu ihrer Drehachse konzentrisch gelagerte Trageinheit umfasst, die ihrerseits einen äußeren, zum Gehäuse der Greifereinheit drehbaren Teil und einen gegenüber diesem äußeren Teil drehfest abgestützten, aber höhenverstellbaren inneren Teil aufweist. Der innere Teil seinerseits ist Träger einer zur Drehachse der Greifereinheit konzentrischen Lagerung für die Hohlwelle, und mit dieser Hohlwelle in Achsrichtung der Drehachse der Greifereinheit, also höhenfest verbunden. Dadurch ist die Hohlwelle in ihrer Höhenlage zum Drehrevolver festgelegt und kann bei einfacher Ausgestaltung die Antriebswelle für den Drehrevolver bilden, wofür die Hohlwelle an ihrem dem Drehrevolver zugewandten Ende mit einem kegeligen Zahnkranz versehen ist, der mit einem entsprechenden Gegenkranz des Drehrevolvers kämmt.

Die Höhenverstellung des gegenüber dem Außenteil axial verschieblichen Innenteil erfolgt zweckmäßigerweise über einen Verstellexzenter, der in eine radial offene Ringnut des Innenteiles eingreift, bei Abstützung seines Antriebes gegen das Gehäuse der Greifereinheit. Diese trägt auch die Antriebsmotoren für den Drehrevolver bzw. die Verdrehung der Trageinheit um die Drehachse der Greifereinheit, so dass sich einfache Antriebsverbindungen ergeben.

Weitere Einzelheiten und Merkmale der Erfindung ergeben sich aus den Ansprüchen. Ferner wird die Erfindung mit weiteren Details anhand der zeichnerischen Darstellung eines Ausführungsbeispieles näher erläutert. Es zeigen:
- Fig. 1: eine perspektivische Gesamtansicht einer erfindungsgemäßen Vorrichtung zum Bestücken von Teileträgern für Mikrosysteme, die insbesondere als Prozessmodul für ein in Clusterbauweise aufgebautes und gegebenenfalls auch in Reinraumtechnik arbeitendes Arbeitszentrum einsetzbar ist,
- Fig. 2: eine Draufsicht auf die Vorrichtung gemäß Fig. 1, in weiterer Schematisierung,
- Fig. 3: eine stark schematisierte Schnittdarstellung durch die Vorrichtung gemäß Fig. 1 bei einer Schnittführung gemäß III-III,
- Fig. 4: einen Schnitt durch die Greifereinheit der Vorrichtung in schematisierter, vereinfachter Darstellung, und
- Fig. 5: eine vergrößerte Darstellung des den Drehrevolver umfassenden Bereiches der Greifereinheit gemäß Fig. 4, ebenfalls schematisiert und vereinfacht.

Die in den Figuren dargestellte Vorrichtung zum Bestücken von Teileträgern ist insgesamt mit 1 bezeichnet und in einem Rahmengestell 2 angeordnet, das im Ausführungsbeispiel rechteckig ist, wobei den Seiten des Rahmengestelles 2 Beschickungsöffnungen 3 zugeordnet sind, die im Hinblick auf die Verwendung der Vorrichtung als Prozessmodul für ein in Clusterbauweise aufgebautes Arbeitszentrum den Zugriff beispielsweise mittels eines Zentriergreifers erlauben, mittels dessen die zu bestückenden Teile, insbesondere in Form scheibenartiger Gebilde, als zu bestückende Werkstücke oder Paletten in die Vorrichtung eingebracht werden können. Der Aufbau ist dabei derart, dass die Vorrichtung auch als Bestandteil in Arbeitszentren eingesetzt werden kann, die unter Reinraumbedingungen arbeiten, so dass in solchen Fällen die die Vorrichtung 1 aufnehmende und in ihren Wänden Beschickungsöffnungen 3 aufweisende Kammer 4 als Unterdruckkammer arbeitet.

Über die Beschickungsöffnungen 3 erfolgt der Zugriff auf Arbeitsinseln 5, welche drehbar als Planeten auf einem darunter liegenden Planetenträger 6 angeordnet sind, wobei die Drehachse des Planetenträgers 6 mit 7 bezeichnet ist, aufrecht, insbesondere vertikal verläuft und die Drehachsen 8 der Arbeitsinseln 5 eine zur Drehachse 7 des Planetenträgers 6 parallele Erstreckung aufweisen und gemeinsam auf einem Zylindermantel, der hier nicht dargestellt ist, liegen, dessen Drehachse mit der Drehachse 7 des Planetenträgers 6 zusammenfällt. Die Drehachse 7 des Planetenträgers 6 ist raumfest gelagert und die um die Drehachsen 8 gegenüber dem Planetenträger 6 drehbaren, Planeten des Planetenträgers 6 bildenden Arbeitsinseln 5 überstreichen bei Drehung des Planetenträgers 6 eine Ringzone, zu der eine Greifereinheit 9 in Überdeckung liegt, deren Gehäuse 10 rahmenfest angeordnet ist und die eine Drehachse 11 aufweist, welche parallel zu den Drehachsen 8 der Planeten 5 und auf dem gleichen Zylindermantel wie diese liegt.

Der Planetenträger 6 ist, was hier nur angedeutet ist, über ein Hubwerk 12, beispielsweise einen Hubzylinder höhenverstellbar, der Motor für den Drehantrieb des Planetenträgers ist bei 13 angedeutet.

Nicht weiter dargestellt ist der Antrieb für die Arbeitsinseln 5 bildenden Planeten, die auf dem Planetenträger 6 drehbar gelagert sind, wobei den Planeten ein gemeinsamer Drehantrieb zugeordnet sein kann. Bevorzugt sind den Planeten als Arbeitsinseln 5 unabhängige Einzelantriebe zugeordnet, und gegebenenfalls können die Arbeitsinseln 5 auch noch einzeln in Hubrichtung verstellbar sein, was ebenfalls nicht dargestellt ist.

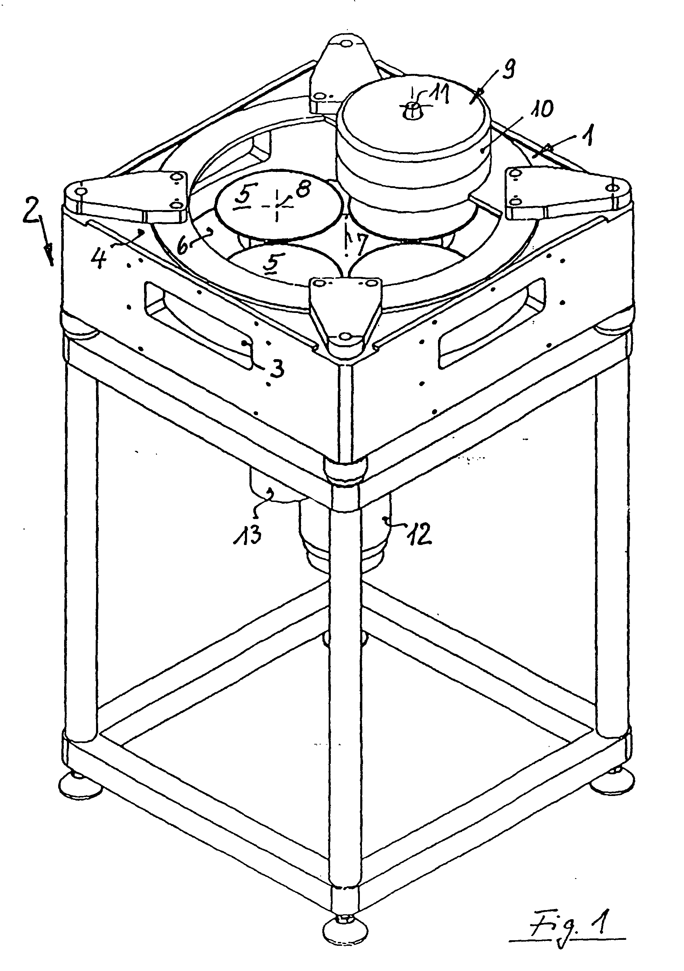

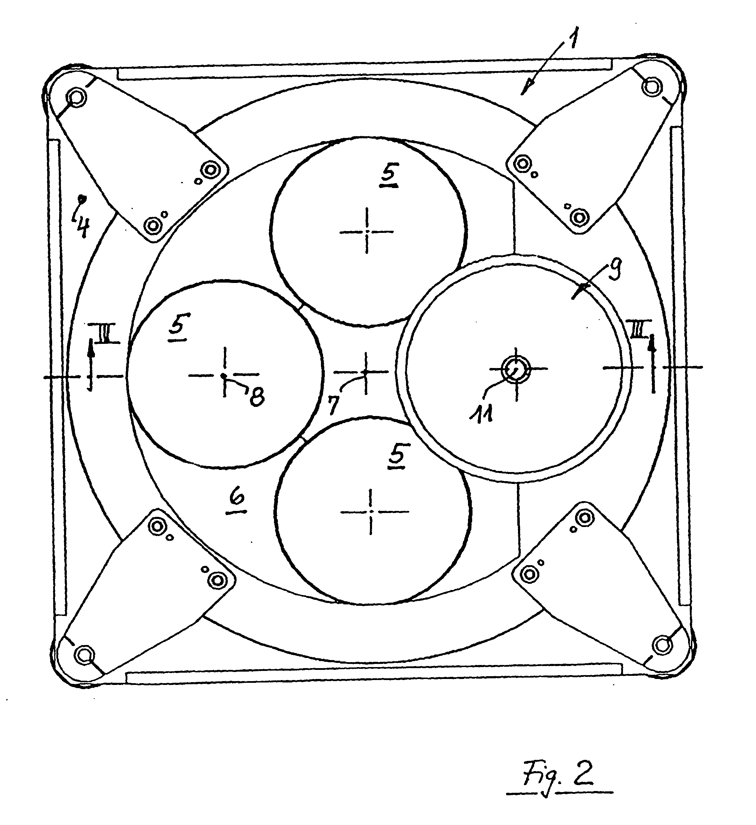

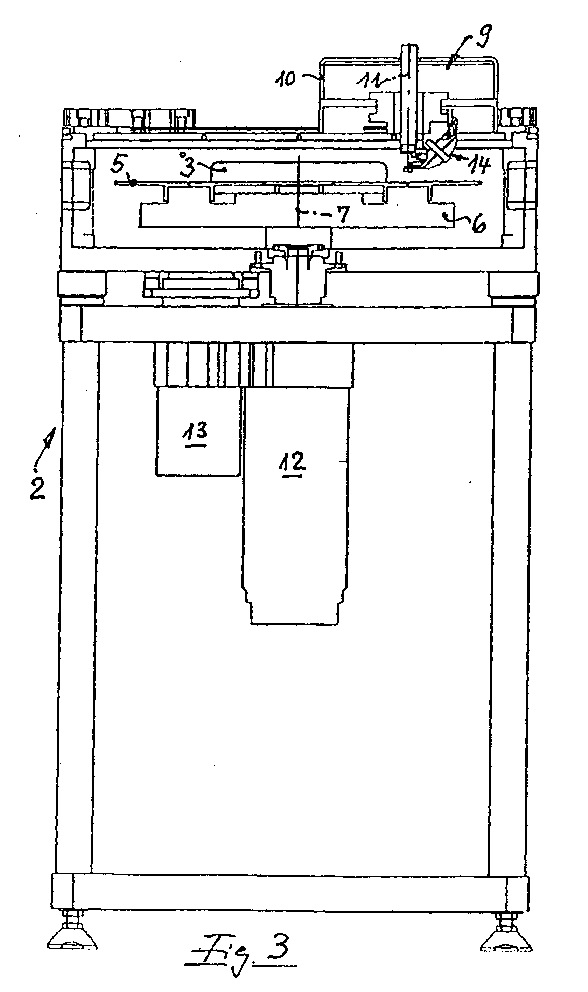

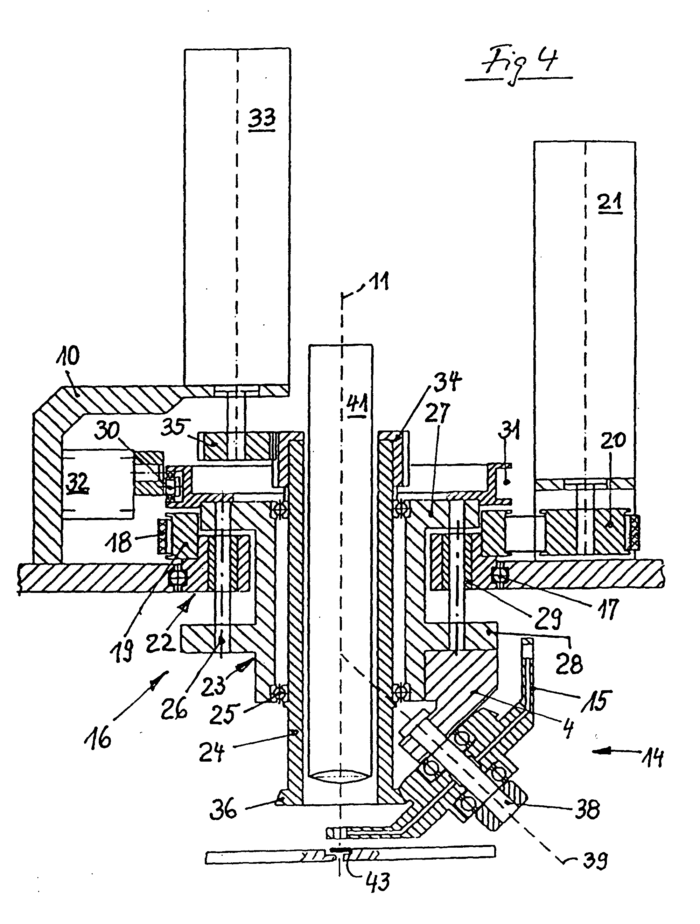

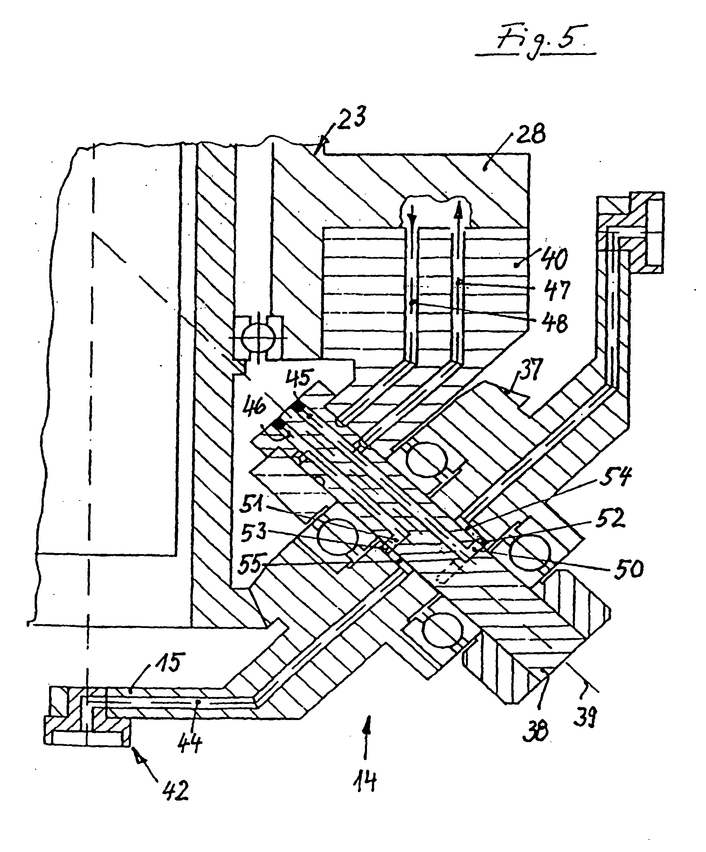

Die in den Fig. 1 und 2 nur in ihren Umrissen angedeutete und in Fig. 3 nur bezüglich ihrer wesentlichsten Elemente im Schnitt dargestellte Greifereinheit 9 ist in weiterer Detaillierung in den Fig. 4 und 5 bezüglich ihrer konstruktiv wesentlichsten Elemente dargestellt. Auch in diesen Fig. ist mit 10 das rahmenfeste Gehäuse der Greifereinheit veranschaulicht, und die zum Rahmen der Vorrichtung lagefeste Drehachse der Greifereinheit wiederum mit 11 bezeichnet.

Fig. 3 bis 5 zeigen als eine bevorzugte Ausgestaltung einer Greifereinheit 9 gemäß der Erfindung deren Ausstattung mit einem Greiferkopf 14, der als Drehrevolver ausgebildet ist und der über seinen Umfang mit Abstand verteilt eine größere Anzahl von Greiferfingern 15 aufweist. Der Drehrevolver ist über eine Trageinheit 16 gegen das Gehäuse 10 der Greifereinheit 9 abgestützt, wobei die Abstützung radial über einen Lagerring 17 erfolgt, der konzentrisch zur Drehachse 11 der Greifereinheit 9 liegt, so dass die Trageinheit 16 der Greifereinheit 9 um die Drehachse 11 der Greifereinheit 9 drehbar ist. Der diesbezügliche Antrieb ist im Ausführungsbeispiel in Fig. 4 als Zahnriemenantrieb mit einem Riemen 18 veranschaulicht, der auf ein Riemenrad 19 der Trageinheit 16 wirkt und dieses mit einem Riemenrad 20 eines Antriebsmotores 21 verbindet, der bei zur Drehachse 11 paralleler Drehachse feststehend zum Gehäuse 10 und bevorzugt innerhalb desselben angeordnet ist.

Das Riemenrad 19 ist Bestandteil des äußeren Teiles 22 der Trageinheit 16, dem gegenüber drehfest, aber in Richtung der Drehachse 11 axial verschiebbar ein Innenteil 23 der Trageinheit 16 angeordnet ist. Das Innenteil 23 bildet den Träger für eine Hohlwelle 24, die sich konzentrisch zur Drehachse 11 erstreckt und die axial unverschieblich drehbar über Lager 25 vom Innenteil 23 getragen ist, wobei das Innenteil 23 wie auch das Außenteil 22 in der Abfolge radial nach außen die Hohlwelle umschließende und gegenüber dem Gehäuse 10 drehbar abstützende Ringteile bilden.

Die axial verschiebliche Abstützung des Innenteiles 23 gegenüber dem Außenteil 22 erfolgt über säulenartige Führungsstifte 26, die in nach außen ragenden, das Außenteil 22 radial teilweise übergreifenden Ringbunden 27 und 28 fixiert sind und in dem radial übergriffenen Bereich des Außenteile 22 über Führungsbuchsen 29 verschiebbar gehalten sind.

Die Höhenverstellung des Innenteils 23, und damit auch des von diesem getragenen Greiferkopfes 14 und der Hohlwelle 24 erfolgt über einen Exzenter 30, der in eine dem Innenteil zugehörige, radial nach außen offene Ringnut 31 eingreift und über einen zum Gehäuse 10 festen Stellmotor 32 angetrieben ist. Bei der über die Verstellung des Exzenters 30 erfolgenden Höhenverstellung des Innenteiles 23 wird als vom Innenteil in Achsrichtung fest getragenes Teil auch die Hohlwelle 24 in Axialrichtung verstellt. Die Hohlwelle 24 ist als Antriebswelle für den als Greiferkopf 14 dienenden Drehrevolver im Übergang zum zugehörigen Antriebsmotor 33 mit einem außen verzahnten Ringrad 34 versehen, dessen Breite zumindest um die Verstellhöhe des Innenteiles 23 breiter als die Breite des Ritzels 35 des Antriebsmotores 33 ist.

Die Hohlwelle 24 läuft an ihrem dem Ringrad 34 gegenüberliegenden unteren und dem Greiferkopf 14 benachbarten Ende in einem radial äußeren, konischen Zahnkranz 36 aus, der mit einem dem Drehrevolver zugehörigen entsprechend konischen Gegenkranz 37 kämmt, wobei der Drehrevolver 14 auf einem Achsbolzen 38 gelagert ist, der die Drehachse 39 des Drehrevolvers 14 bestimmt und der an einer Tragkonsole 40 des Innenteiles 23 befestigt ist. Die Drehachse 39 des Drehrevolvers als Greiferkopf 14 erstreckt sich unter einem Winkel von 45° zur Drehachse 11, die Greiferarme 15 erstrecken sich zur Drehachse 39 des Greiferkopfes 14 in entsprechender Weise unter einem Winkel von 45° und liegen auf einem Kegelmantel mit einem Kegelwinkel von 90°, bei auf der Drehachse 39 liegender Kegelspitze. Dementsprechend bewegen sich die Greiferfinger 15 im Durchlauf durch die Drehachse 11 der Greifereinheit 9 tangential zu einer zur Drehachse 11 senkrechten Ebene, und damit parallel zur Tischfläche der durch die Planeten, gebildeten Arbeitsinseln 5.

In dem von der Hohlwelle 24 umschlossenen zylindrischen Raum ist eine Beobachtungsoptik 41 angeordnet, die beispielsweise durch eine Linsenkonfiguration gebildet sein kann und die drehfest gegenüber dem Rahmengestell 2 in hier nicht näher dargestellter Weise angeordnet ist. Gegebenenfalls ist die Beobachtungsoptik zur Scharfstellung in Richtung der Drehachse 11 längenverstellbar; eine bevorzugte Ausbildung ist die Gestaltung als Zoom-Objektiv.

Bevorzugt erfolgt die Zuordnung derart, dass eine Scharfstellung auf in Arbeitshöhe der Arbeitsinseln 5 gelegene Bauteile 43 gegeben ist. Die Höhenverstellbarkeit des Greiferkopfes 14 über den Exzenter 30 dient bevorzugt dazu, den Greiferkopf 14 bezüglich des jeweiligen Greiferarmes 15 an den hier nicht dargestellten, auf der jeweiligen Arbeitsinsel 5 liegenden Teileträger soweit axial heranzufahren, dass das jeweils aufzunehmende Bauteil 43 erfasst werden kann, wobei diese Erfassung im Rahmen der Erfindung bevorzugt über einen Saugstempel erfolgt, wie er in Fig. 5 bei 42 symbolisch dargestellt ist.

In der Zeichnung ist in den Fig. 4 und 5 des Weiteren angedeutet, dass die Luftversorgung für die jeweiligen Saugstempel 42 über jeweils einen Kanal 44 in den Greiferfingern 15 und über je einen Saugkanal 45 bzw. Druckkanal 46 im Achsbolzen 38 und entsprechende, dem Innenteil 23 zugehörige Anschlusskanäle 47, 48 erfolgt. Bevorzugt ist dabei der Anschluss der Luftführung im Übergang des Drehrevolvers 14 auf den Achsbolzen 18 derart gestaltet, dass drehstellungsabhängig der am Saugstempel anliegende Unterdruck aufgehoben wird, wenn die gewünschte Ablagestellung erreicht wird, der Saugdruck aber über dem Umlaufweg des Greiferkopfes so lange aufrechterhalten wird, wie dies zur Sicherung des Bauteiles 43 in der jeweiligen Aufnahmelage gegenüber dem Saugstempel 42 erforderlich ist. Für die Freigabe kann gegebenenfalls, statt Überdruck einzusteuern, ein Anschluss an die Atmosphäre erfolgen. Die gesteuerte Verbindung zwischen den im Achsbolzen 38 vorgesehenen Kanälen 45 und 46 zum Kanal 44 im jeweiligen Greiferarm 15 erfolgt im Ausführungsbeispiel über Radialbohrungen 50, 51 im Achsbolzen 38, zu denen ringförmige Aussparungen 52, 53 in Überdeckung liegen, die dem umlaufenden Greiferkopf 14 zugeordnet sind und deren Erstreckung in Umfangsrichtung die jeweilige Versorgungszeit bestimmt. Diese Aussparungen 52, 53 sind über Axialkanäle 54, 55 jeweils mit dem Kanal 44 verbunden.

Mittels der geschilderten Vorrichtung kann eine Umsortierung von Bauteilen beispielsweise von mit gleichen Bauteilen belegten Paletten, die einzelnen Arbeitsinseln 5 zugeordnet sind, auf eine oder mehrere andere Paletten erfolgen, die gemischt zu belegen sind. Es kann aber auch eine Umsortierung der auf einer Arbeitsinsel vorgesehenen Bauteile bezüglich der dieser Arbeitsinsel zugeordneten Palette erfolgen. Im Rahmen der Erfindung ist es weiter möglich, die jeweilige Palette quasi mehrgeteilt auszuführen, so erfindungsgemäß mit einem äußeren Ringrahmen, der als Träger für Bauteile dient und gleichzeitig als Träger für ein dem mittleren Bereich der Palette zugeordneter und über die Palette getragenes Werkstück, auf das von der Palette getragene Bauteile in vorgegebener Weise umgesetzt werden. Die erfindungsgemäße Anordnung ermöglicht dabei nicht nur die Platzierung auf der Palette bzw. im Werkstück in der gewünschten Weise bezüglich des jeweiligen Platzierungsortes, sondern auch in der konturgerechter Zuordnung bei unrunden oder lageorientiert abzulegenden Bauteilen, und zwar aufgrund der Verdrehbarkeit der Greifereinheit 9 insgesamt um die Drehachse 11.

Die Beobachtungsoptik 41 ermöglicht im Rahmen der geschilderten Konstruktion neben der Bauteilerkennung gegebenenfalls auch eine Bauteilkontrolle, sowie die Positionierungskontrolle. Insbesondere im Hinblick auf diese Beobachtungsfunktion erweist es sich als zweckmäßig, die Greiferfinger verhältnismäßig schmal auszubilden, um trotz einer größeren Anzahl von Greiferfingern ausreichende Beobachtungssektoren frei zu halten.

Im Ausführungsbeispiel sind dem Planetenträger vier Arbeitsinseln 5 zugeordnet, und es ist des Weiteren eine Greifereinheit 9 vorgesehen. Im Rahmen der Erfindung liegt es selbstverständlich, einen Planetenträger gegebenenfalls mit einer abweichenden Anzahl von Arbeitsinseln auszustatten und anstelle einer Greifereinheit gegebenenfalls auch mehrere Greifereinheiten vorzusehen.

## Patentansprüche

1. Vorrichtung zum Bestücken von Teileträgern für Mikrosysteme, insbesondere ein Prozessmodul für in Clusterbauweise aufgebaute Arbeitszentren, umfassend einen um eine zentrale Achse (7) drehbaren Planetenträger (6) mit Planeten als Arbeitsinseln (5), dem eine drehbare Greifereinheit (9) zugeordnet ist, die einen im Überdeckungsbereich zur von den Arbeitsinseln (5) bei Drehung des Planetenträgers (6) bestrichenen Ringfläche liegenden Arbeitspunkt aufweist, der auf einer Kreislinie durch die Drehachsen (8) der Arbeitsinseln (5) liegt, wobei der Mittel-punkt der kreislinie mit der Drehachse (7) des Planetenträgers (6) zusammenfällt,
**dadurch gekennzeichnet,**
**dass** die Drehachsen (8) der Arbeitsinseln (5) zusammen mit der vorrichtungsfesten Drehachse (11) der Greifereinheit (9) auf einem zur Drehachse (7) des Planetenträgers (6) konzentrischen Zylindermantel liegen.

2. Vorrichtung nach Anspruch 1,
**dadurch gekennzeichnet,**
**dass** die Arbeitsinseln (5) voneinander unabhängig höhenverstellbar sind.

3. Vorrichtung nach Anspruch 1 oder 2,
**dadurch gekennzeichnet,**
**dass** die Greifereinheit (9) einen Greiferkopf (14) umfasst, der als Drehrevolver mit über seinen Umfang zueinander beabstandeten Greiferfingern (15) ausgebildet ist und dessen Greiferfinger (15) im Durchlauf durch die Drehachse (11) der Greifereinheit (9) diese senkrecht schneiden.

4. Vorrichtung nach Anspruch 3,
**dadurch gekennzeichnet,**
**dass** die Drehachse (39) des Greiferkopfes (14) unter einem Winkel von 45° zur Drehachse (11) der Greifereinheit (9) geneigt ist und diese schneidet.

5. Vorrichtung nach einem der vorhergehenden Ansprüche 3 oder 4,
**dadurch gekennzeichnet,**
**dass** der Greifereinheit (9) eine auf den Arbeitspunkt des Greiferkopfes (14) ausgerichtete, in der Drehachse (11) der Greifereinheit (9) liegende Beobachtungsoptik (41) zugeordnet ist.

6. Vorrichtung nach Anspruch 5,
**dadurch gekennzeichnet,**
**dass** der Greiferkopf (14) von einer zur vorrichtungsfesten Drehachse (11) der Greifereinheit (9) konzentrischen Hohlwelle (24) angetrieben ist, die die Beobachtungsoptik (41) umschließt.

7. Vorrichtung nach Anspruch 6,
**dadurch gekennzeichnet,**
**dass** die Hohlwelle (24) in Richtung der Drehachse (11) der Greifereinheit (9) axial verschieblich ist und dass der Greiferkopf (14) über eine zur Hohlwelle (24) konzentrische Trageinheit (16) gehalten ist, die ihrerseits vorrichtungsfest drehbar gelagert ist.

8. Vorrichtung nach Anspruch 7,
**dadurch gekennzeichnet,**
**dass** die Trageinheit (16) einen vorrichtungsfesten, drehbar abgestützten äußeren Teil (22) und einen gegenüber diesem axial verstellbaren Innenteil (23) aufweist, der den Greiferkopf (14) und die Lagerung für die Hohlwelle (24) trägt.

9. Vorrichtung nach Anspruch 7,
**dadurch gekennzeichnet,**
**dass** die Hohlwelle (24) einen Zahnkranz (36) trägt, dem an dem den Greiferkopf (14) bildenden Drehrevolver ein Gegenkranz (37) zugeordnet ist.

10. Vorrichtung nach einem der Ansprüche 7 bis 9,
**dadurch gekennzeichnet,**
**dass** die Hohlwelle (24) mit einem sie tragenden Innenteil (23) in Achsrichtung unverschieblich verbunden ist und dass der Innenteil (23) durch einen vorrichtungsfest abgestützten Exzenter (30) in Achsrichtung verstellbar ist.

11. Vorrichtung nach einem der Ansprüche 8 bis 10,
**dadurch gekennzeichnet,**
**dass** der Greiferkopf (14) auf einem gegenüber dem Innenteil (23) feststehenden Achsbolzen (38) gelagert und an seinen Greiferfingern (15) im Bereich des Arbeitspunktes mit Saugstempeln (42) versenen ist, denen durch den Achsbolzen (38) des Greiferkopfes (14) verlaufende Versorgungsleitungen zugeordnet sind.

## Claims

1. Apparatus for populating component supports for microsystems, in particular a process module for work centres built up in a cluster design, comprising a planet carrier (6) which can rotate about the central axis (7) and has planets as working islands (5), to which a rotatable gripper unit (9) is assigned which has a working point located in the overlap area of the annular area covered by the working islands (5) during rotation of the planet carrier (6) and which lies on a circular line through the axes of rotation (8) of the working islands (5), the centre of the circular line coinciding with the axis of rotation (7) of the planet carrier (6), **characterized in that** the axes of rotation (8) of the working islands (5), together with the axis of rotation (11), fixed to the apparatus and belonging to the gripper unit (9), lie on a cylinder shell which is concentric with the axis of rotation (7) of the planet carrier (6).

2. Apparatus according to Claim 1, **characterized in that** the working islands (5) can be adjusted vertically independently of one another.

3. Apparatus according to Claim 1 or 2, **characterized in that** the gripper unit (9) comprises a gripper head (14) which is constructed as a turret with gripper fingers (15) spaced apart from one another over its circumference and whose gripper fingers (15), as they pass through the axis of rotation (11) of the gripper unit (9), intersect the said axis at right angles.

4. Apparatus according to Claim 3, **characterized in that** the axis of rotation (39) of the gripper head (14) is inclined at an angle of 45° to the axis of rotation (11) of the gripper unit (9) and intersects the said axis.

5. Apparatus according to one of the preceding claims 3 or 4, **characterized in that** the gripper unit (9) is assigned observation optics (41) aligned with the working point of the gripper head (14) and located on the axis of rotation (11) of the gripper unit (9).

6. Apparatus according to Claim 5, **characterized in that** the gripper head (14) is driven by a hollow shaft (24) which is concentric with the axis of rotation (11) fixed to the apparatus and belonging to the gripper unit (9), and which encloses the observation optics (41).

7. Apparatus according to Claim 6, **characterized in that** the hollow shaft (24) can be displaced axial in the direction of the axis of rotation (11) of the gripper unit (9), and **in that** the gripper head (14) is held by a supporting unit (16) which is concentric with the hollow shaft (24) and which in turn is mounted fixed to the apparatus such that it can rotate.

8. Apparatus according to Claim 7, **characterized in that** the supporting unit (16) has an outer part (22) which is fixed to the apparatus but supported such that it can rotate and an inner part (23) which is axially adjustable with respect to the said outer part and which carries the gripper head (14) and the mounting for the hollow shaft (24).

9. Apparatus according to Claim 7, **characterized in that** the hollow shaft (24) bears a toothed ring (36) to which, on the turret forming the gripper head (14), a mating ring (37) is assigned.

10. Apparatus according to one of Claims 7 to 9, **characterized in that** the hollow shaft (24) is connected to an inner part (23) that supports it such that it cannot be displaced in the axial direction, and **in that** the inner part (23) can be adjusted in the axial directiond by an eccentric (30) which is supported fixed to the apparatus.

11. Apparatus according to one of Claims 8 to 10, **characterized in that** the gripper head (14) is mounted on an axle pin (38) which is stationary with respect to the inner part (23) and, on its gripper fingers (15), in the region of the working point, is provided with suction plungers (42) to which supply lines running through the axle pin (38) of the gripper head (14) are assigned.

## Revendications

1. Dispositif pour équiper des supports de pièces pour microsystèmes, en particulier un module de processus pour des centres opérationnels structurés à la manière d'un cluster, comprenant un support planétaire (6) pouvant tourner autour d'un axe central (7) avec des planètes en guise d'îlots de travail (5), auquel est affectée une unité de pince (9) rotative présentant un point de fonctionnement dynamique situé dans la zone de recouvrement par rapport à la surface d'anneau balayée par les îlots de travail (5) lors de la rotation du support planétaire (6), lequel se situe sur un cercle traversant les axes de rotation (8) des îlots de travail (5), moyennant quoi le point central du cercle coïncide avec l'axe de rotation (7) du support planétaire (6), **caractérisé en ce que** les axes de rotation (8) des îlots de travail (5) reposent ensemble avec l'axe de rotation (11) fixe avec le dispositif de l'unité de pince (9) sur un corps de cylindre concentrique par rapport à l'axe de rotation (7) du support planétaire (6).

2. Dispositif selon la revendication 1, **caractérisé en ce que** les îlots de travail (5) peuvent être réglés en hauteur indépendamment les uns des autres.

3. Dispositif selon la revendication 1 ou 2, **caractérisé en ce que** l'unité de pince (9) comprend une tête de pince (14) réalisée en tant que tour revolver avec des doigts de pince (15) à distance les uns des autres sur tout son pourtour, et dont les doigts de pince (15), lors du passage via l'axe de rotation (11) de l'unité de pince (9), le coupent perpendiculairement.

4. Dispositif selon la revendication 3, **caractérisé en ce que** l'axe de rotation (39) de la tête de pince (14) est incliné avec un angle de 45° par rapport à l'axe de rotation (11) de l'unité de pince (9) et le coupe.

5. Dispositif selon l'une quelconque des revendications précédentes 3 ou 4, **caractérisé en ce qu'**une optique d'observation (41) orientée vers le point de fonctionnement dynamique de la tête de pince (14) et située dans l'axe de rotation (11) de l'unité de pince (9) est affectée à l'unité de pince (9).

6. Dispositif selon la revendication 5, **caractérisé en ce que** la tête de pince (14) est entraînée par un arbre creux (24) concentrique par rapport à l'axe de rotation (11) fixe avec le dispositif de l'unité de pince (9) et entourant l'optique d'observation (41).

7. Dispositif selon la revendication 6, **caractérisé en ce que** l'arbre creux (24) peut se déplacer axialement en direction de l'axe de rotation (11) de l'unité de pince (9), et **en ce que** la tête de pince (14) est tenue via une unité de support (16) concentrique par rapport à l'arbre creux (24), qui est quant à elle montée de manière à pouvoir tourner en solidarité avec le dispositif.

8. Dispositif selon la revendication 7, **caractérisé en ce que** l'unité de support (16) présente une partie extérieure (22) fixe avec le dispositif et supportée de manière rotative, et une partie intérieure (23) pouvant être déplacée axialement par rapport à la partie extérieure, laquelle porte la tête de pince (14) et la disposition des paliers pour l'arbre creux (24).

9. Dispositif selon la revendication 7, **caractérisé en ce que** l'arbre creux (24) porte une couronne dentée (36) à laquelle est affectée une contre-couronne (37) sur le tour revolver formant la tête de pince (14).

10. Dispositif selon l'une quelconque des revendications 7 à 9, **caractérisé en ce que** l'arbre creux (24) est relié de manière non déplaçable en direction de l'axe avec une partie intérieure (23) qui le porte, et **en ce que** la partie intérieure (23) peut être déplacée en direction de l'axe via un excentrique (30) supporté en solidarité avec le dispositif.

11. Dispositif selon l'une quelconque des revendications 8 à 10, **caractérisé en ce que** la tête de pince (14) est montée sur un tourillon d'axe (38) fixe par rapport à la partie intérieure (23) et est pourvue de pistons d'aspiration (42) sur ses pinces (15) dans la zone du point de fonctionnement dynamique, auxquels sont affectées des conduites d'alimentation s'étendant à travers le tourillon d'axe (38) de la tête de pince (14).
